(19) Europäisches Patentamt

European Patent Office

Office européen des brevets

(11) **EP 0 907 878 B1**

(12) **EUROPEAN PATENT SPECIFICATION**

(45) Date of publication and mention
of the grant of the patent:
**25.09.2002 Bulletin 2002/39**

(51) Int Cl.⁷: **G01D 5/244**

(86) International application number:
**PCT/GB97/01762**

(21) Application number: **97929398.2**

(22) Date of filing: **30.06.1997**

(87) International publication number:
**WO 98/000921 (08.01.1998 Gazette 1998/01)**

(54) **APPARATUS AND METHOD FOR PROCESSING SIGNALS OBTAINED FROM A POSITION ENCODER**

GERÄT UND VERFAHREN ZUR VERARBEITUNG VON SIGNALEN EINES POSITIONSGEBERS

APPAREIL ET PROCEDE SERVANT A TRAITER DES SIGNAUX OBTENUS DEPUIS UN CODEUR DE POSITION

(84) Designated Contracting States:
**AT BE CH DE DK ES FI FR GB GR IE IT LI LU MC NL PT SE**

(30) Priority: **28.06.1996 GB 9613673**

(43) Date of publication of application:
**14.04.1999 Bulletin 1999/15**

(73) Proprietor: **Synaptics (UK) Limited
Harston, Cambridgeshire CB2 5NH (GB)**

(72) Inventors:
• **ELY, David, Thomas, Eliot
Cambridge CB1 3PH (GB)**
• **DAMES, Andrew, Nicholas
Cambridge CB4 1HU (GB)**

(74) Representative: **Beresford, Keith Denis Lewis
BERESFORD & Co.
2-5 Warwick Court,
High Holborn
London WC1R 5DH (GB)**

(56) References cited:
**WO-A-95/31696          US-A- 3 482 242**

• **ELECTRICAL DESIGN NEWS, vol. 16, no. 12, 15 June 1971, pages 53-56, XP002045871 R. KLATT: "Phase of Digital Data Fixes Shaft Angle"**
• **PATENT ABSTRACTS OF JAPAN vol. 010, no. 009 (P-420), 14 January 1986 & JP 60 165512 A (TOSHIBA KK), 28 August 1985,**

**Description**

The present invention relates to an apparatus and method for processing signals received from a position encoder. The present invention may be used to determine the position of two relatively movable members from signals received from a position encoder used to determine their relative positions, wherein the positional information is encoded within the amplitude of a number of carrier signals output from the position encoder.

Many types of non-contact linear and rotary position encoders have been proposed for generating signals indicative of the position of two relatively movable members. Typically, one of the members carries one or more sense coils and the other carriers one or more magnetic field generators. The magnetic field generators and the sense coils are arranged such that the amount of magnetic coupling between the magnetic field generators and the sense coils varies as a function of the relative position of the two members.

In some of these non-contact position encoders, the sense windings and the magnetic field generators are designed to try and make the output signal vary linearly with the relative position between the two members, since this reduces the complexity of the signal processing required to determine the positional information. However, it is difficult to design a system which is exactly linear and they are usually relatively sensitive to variations in the gap between the sense coils and the magnetic field generators.

The applicant's earlier International Patent Application WO95/31696 discloses several examples of similar non-contact position encoders in which the output signal from each sense coil varies sinusoidally as a function of the relative position of two movable members. However, in order to derive the positional information, more complex processing of the received signals is required. In particular, where two phase-quadrature sense coils are used, the signal from each is demodulated and a ratiometric arc-tangent calculated in order to obtain the positional information. Although the ratiometric arc-tangent calculation reduces the system's sensitivity to variations in the gap between the two relatively movable members, it requires relatively complex processing calculations which are usually performed by a microprocessor under software control.

The article by R. Klatt entitled "Phase of Digital Data Fixes Shaft Angle", Electric design news, vol. 16, 15 Juni 1971, nr. 12, pages 53-56, describes an apparatus for processing signals from a position detector, in which the signals are sampled by periodic signals having different predetermined phases and added for obtaining an output signal.

An aim of the present invention is to provide an alternative method and apparatus for processing signals which vary sinusoidally with the relative position between the two relatively movable members. Such a method and an apparatus are defined in claims 1 and 18.

According to another aspect the present invention provides processing circuitry, as defined in claim 29, for processing signals received from a position encoder used to determine the relative position between two relatively movable members in which the received signals are combined with an intermediate frequency signal having a phase which depends upon the phase of the received signal.

Further embodiments of the invention are defined in dependent claims.

The present invention provides a processing apparatus for processing a number of signals received from a position encoder used to encode the relative positions of a number of relatively movable members, wherein each of the received signals varies in a similar manner with said relative position but having differing phases, the apparatus comprising: means for combining each of the received signals with a respective one of a corresponding number of the periodically varying signals, each varying in a similar manner but with a different predetermined phase; and means for adding the combined signals to provide an output signal, and wherein the predetermined phases of said periodically varying signals are determined so that said output signal from said adding means contains a single periodically varying component whose phase varies with said relative position.

The present invention provides a method of processing a number of signals received from a position encoder used to encode the relative positions of a number of relatively movable members, wherein each of the received signals varies in a similar manner with said relative position, but out of phase with respect to each other, the method comprising the steps of: combining each of the received signals with a respective one of a corresponding number of periodically varying signals, each varying in a similar manner but with a different predetermined phase; and adding the combined signals to provide an output signal, and wherein the predetermined phases of the periodically varying signals are determined so that the output signal contains a single periodically varying component whose phase varies with said relative position.

The present invention also provides a position detector comprising a number of sensing circuits, each extending over a measurement path and being offset from each other; generator means, being mounted for relative movement over the measurement path, for generating a signal in each of the sensing circuits which varies as a function of the relative position between said generating means and the sensing circuit, whereby, the phase of each of said generated signals is different due to the offset between each of said sensor circuits over said measurement path; means for combining each of the received signals with a respective one of a corresponding number of periodically varying signals, each varying in a similar manner but with a different predetermined phase; and means for adding the signals from the combining means to provide an output signal; wherein said predetermined phases of said periodically varying signals are determined so that said output signal from said adding means contains a single periodic component whose phase varies with the relative position between said generator means and said sensing circuit.

Preferably the sensing circuits are evenly spaced over the measurement path and the predetermined phases of the periodically varying signals are made equal in magnitude to the phase of the signals from the corresponding sensing circuit, since these can be easily calculated in advance.

Exemplary embodiments of the invention will now be described with reference to the accompanying drawings, in which:

Figure 1 schematically illustrates a rotating shaft having a position encoder mounted relative thereto, for encoding the position of the rotatable shaft;

Figure 2a is a schematic view of three sense coils formed on a printed circuit board which forms part of the position encoder shown in Figure 1;

Figure 2b shows a top layer of printed conductors forming part of the printed circuit board shown in Figure 2a;

Figure 2c shows the bottom layer of printed conductors forming part of the printed circuit board shown in Figure 2a;

Figure 3 illustrates the form of an electrically resonant circuit forming part of the position encoder shown in Figure 1;

Figure 4 illustrates the way in which the peak amplitude of the signal induced in each sense coil varies with the angular position of the rotatable shaft;

Figure 5 is a schematic representation of excitation and processing circuitry embodying the present invention for determining the angular position of the rotatable shaft;

Figure 6a illustrates the way in which one of the output signals from the processing circuitry shown in Figure 5 varies with time;

Figure 6b illustrates the way in which the duty ratio of the output signal shown in Figure 6a varies with the angular position of the rotatable shaft;

Figure 6c illustrates the way in which the ratio of an output voltage from the processing circuitry shown in Figure 5 to the supply voltage, varies with the angular position of the rotatable shaft;

Figure 7a shows a circuit diagram of a part of the excitation circuitry schematically shown in Figure 5;

Figure 7b shows a circuit diagram of the rest of the excitation circuitry schematically shown in Figure 5;

Figure 7c shows a circuit diagram of part of the processing circuitry schematically shown in Figure 5; and

Figure 7d shows a circuit diagram of the rest of the processing circuitry schematically shown in Figure 5.

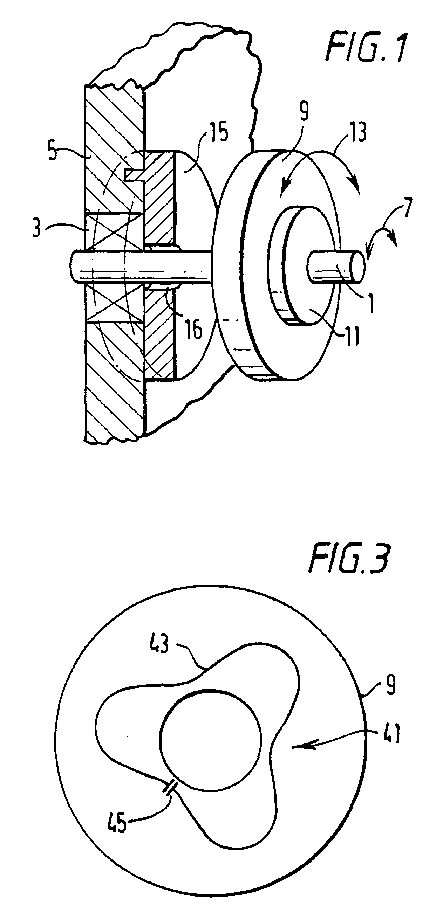

Figure 1 schematically shows a shaft 1 which is rotatable about its axis as represented by the arrow 7 and which passes through a bearing 3 provided in a support wall 5. A first printed circuit board 9 carrying a magnetic field generator (not shown), is mounted for rotation (as represented by arrow 13) with the shaft 1 via a bushing 11 next to a second printed circuit board 15 (shown in cross-section) which carries a number of sense coils (not shown) and an excitation coil (not shown). The second printed circuit board 15 is fixed to the support wall 5 and has a central hole 16 through which the rotatable shaft 1 passes. Preferably, the separation between the circuit 59 and the circuit board 15 is between 0.1 and 4 mm in order to obtain reasonably large signals from the sense coils (not shown).

The arrangement of the magnetic field generator on circuit board 9 and the sense coils on circuit board 15 are such that when the magnetic field generator generates a magnetic field, a signal is induced in each of the sense coils, the peak amplitude of which varies sinusoidally with the angle of rotation of the shaft 1. The signals induced in the sense coils are supplied to processing circuitry (not shown) where the rotational angle of the rotatable shaft 1 is determined.

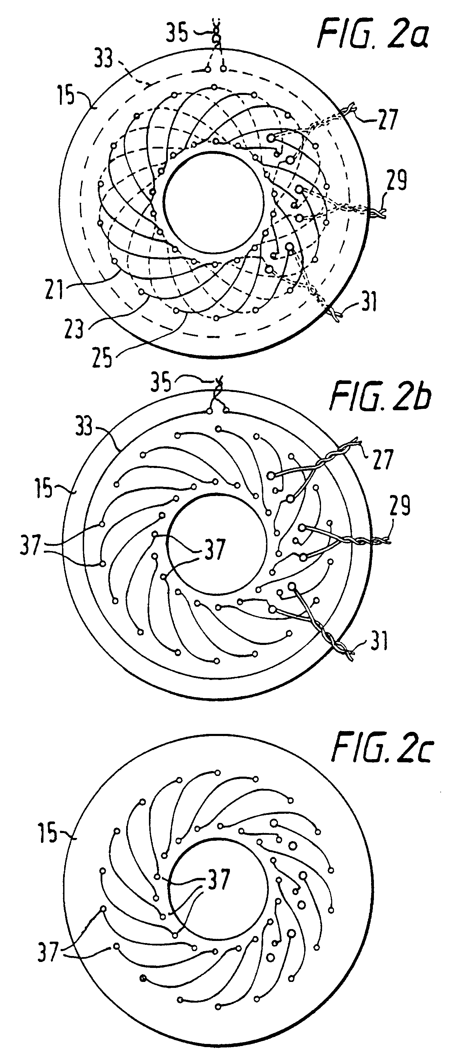

In this embodiment, three periodic sense coils are used which extend circumferentially around the circuit board 15. Each sense coil comprises three periods of windings which are circumferentially spaced apart by 20°. Figure 2a shows the conductors on the printed circuit board 15 which form these three sense coils 21, 23 and 25. Each sense coil 21, 23 and 25 comprises six loops of series connected conductors, connected such that adjacent loops are wound in the opposite sense. This makes the sense coils relatively immune to background electromagnetic interference. The angle over which one period of each sense coil extends is 120°. The ends of the sense coils 21, 23 and 25, are connected to processing circuitry (not shown) by the twisted wire pairs 27, 29 and 31 respectively. Figure 2a also shows the conductor which forms the excitation coil 33 which is connected to excitation circuitry (not shown) by twisted wire pair 35.

Figures 2b and 2c illustrate the way in which the sense coils 21, 23 and 25 and the excitation coil 33 shown in Figure 2a are formed by a top and bottom layer of printed conductors formed on the printed circuit board 15. The conductors on the top and bottom layers are connected, where appropriate, through via holes, some of which are referenced 37.

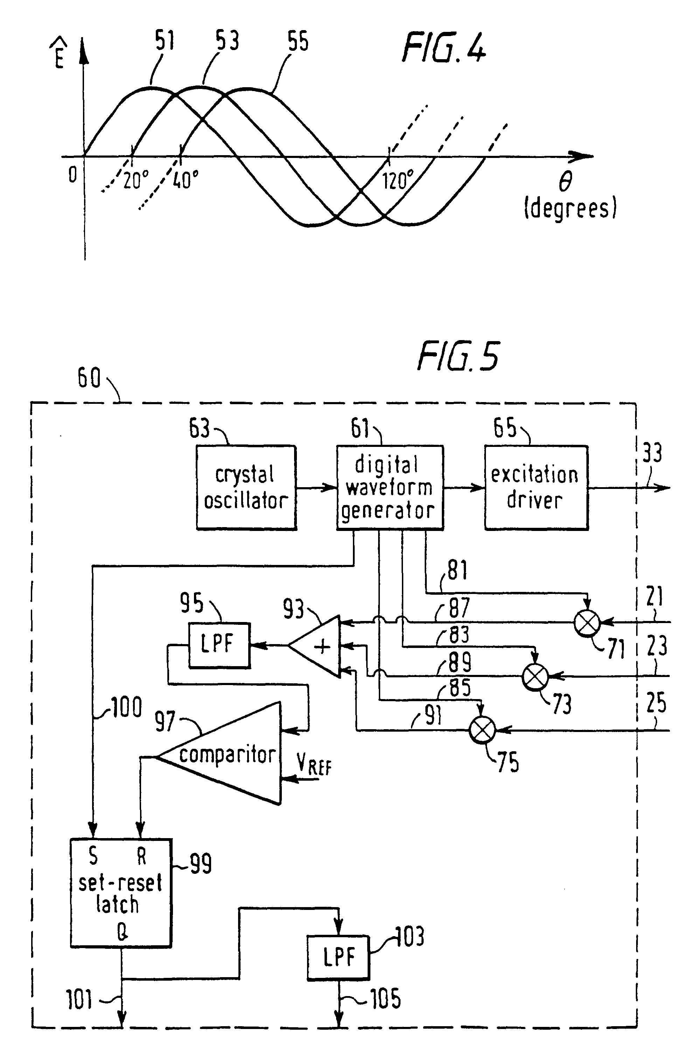

Figure 3 shows the conductor on the printed circuit board 9 which forms the magnetic field generator 41. In this embodiment, the magnetic field generator comprises an electrically resonant circuit 41 having an inductor coil 43 and a capacitor 45. Other types of magnetic field generators could be used, such as, a short circuit coil or a conductive plate.

The principle of operation of the position encoder formed by the sense coils 21, 23 and 25, the excitation coil 33 and the resonant circuit 41 will now be briefly described. A more detailed explanation of the principle of operation of this position encoder and similar position encoders can be found in the applicant's earlier International Patent Application WO95/31696, the content of which is hereby incorporated by reference.

In operation, an AC excitation current is applied to the excitation coil 33 for energising the resonant circuit 41. In response, the resonant circuit 41 generates a magnetic field which induces an Electro-Motive Force (EMF) in each of the sense coils 21, 23 and 25, the amplitude of which varies sinusoidally with the relative position between the resonator and the sense coil. Preferably, the fundamental frequency of the excitation current applied to the excitation coil 33 corresponds with the resonant frequency of the resonant circuit 41, since this provides the maximum signal output.

Figure 4 illustrates the way in which the peak amplitude (Ê) of the EMF's generated in the sense coils 21, 23 and 25 vary with the rotation angle (θ) of the resonant circuit 41. As shown, the respective peak amplitudes 51, 53 and 55 vary sinusoidally and repeat every third of a revolution of the resonant circuit 41 (and hence of the rotatable shaft 1) and are separated by 1/6 of a period from each other. Therefore, the angular position of the rotatable shaft 1 can be determined unambiguously through 120° by suitable processing of the induced signals. This position encoder would, therefore, be suitable for determining the angular position of a throttle valve in an engine, which only rotates through 90 degrees.

Figure 5 schematically represents excitation and processing circuitry 60 embodying the present invention, which is used to excite the excitation coil 33 and to process the signals induced in the sense coils 21, 23 and 25. The excitation signal is generated by the digital waveform generator 61 which receives an oscillating input from a crystal oscillator 63. In this embodiment, the excitation signal is a squarewave voltage having a fundamental frequency $F_0$ (e. g. 1MHz) which is applied to an excitation driver 65 which drives the excitation coil 33.

As mentioned above, the energisation of the excitation coil energises the resonant circuit 41, which in turn generates a magnetic field which induces an EMF in each of the sense coils. The EMF's induced in the sense coils 21, 23 and 25 will include the following components respectively:

$$EMF_{21} = A_0 \ COS[\frac{2\pi\theta}{\lambda}]COS[2\pi F_0 t]$$

$$EMF_{23} = A_0 \ COS[\frac{2\pi\theta}{\lambda} + \frac{\pi}{3}]COS[2\pi F_0 t]$$

$$EMF_{25} = A_0 \ COS[\frac{2\pi\theta}{\lambda} + \frac{2\pi}{3}]COS[2\pi F_0 t] \tag{1}$$

Where $A_0$ is the coupling coefficient between the resonant circuit 41 and the sensor coils 21, 23 and 25, which depends upon, among other things, the separation between the sensor coils 21, 23 and 25 and the resonant circuit 41; λ is the repeat angle, ie, the angle over which one period of each sense coil extends, which, in this embodiment, equals 120°; θ is the rotation angle of the resonant circuit 41 (and hence of the rotatable shaft 1); and $F_0$ is the fundamental frequency of the excitation current applied to the excitation coil 33. There is an additional phase term in the amplitude component of the EMF induced in sense coils 23 and 25 due to the circumferential offset between the sense coils 21, 23 and 25 (the signal induced in sense coil 21 acting as the reference phase). These phase terms will be referred to hereinafter as the sense signal phase.

The induced EMF's are applied to mixers 71, 73 and 75 respectively, where they are multiplied with signals 81, 83 and 85 respectively. Each of the mixing signals 81, 83 and 85 comprises two periodic time varying components.

In this embodiment the first component ($V_1$) is a squarewave corresponding to the squarewave voltage applied to the excitation coil 33 but having a 90° offset to compensate for the phase change due to the resonator 41. In this embodiment, the second component ($V_2$) is also a squarewave signal but has a lower fundamental frequency $F_{IF}$ (e.g. 10.417 KHz) and, in this embodiment, a phase the same as the above mentioned sense signal phase from the corresponding sense coil 21, 23 or 25. The first component effectively demodulates the amplitude modulated EMF induced in the corresponding sense coil and the second component re-modulates it to an intermediate frequency $F_{IF}$.

The advantage of using squarewave signals for mixing with the incoming signal from the corresponding sense coil is that the digital waveform generator 61 can multiply these two signals together by simply performing an exclusive-or (XOR) function on the two squarewave components. This is because the high level of the squarewave signal represents positive one and the low level represents negative one. This can be easily verified by considering the truth table of an XOR gate. Additionally, by using squarewave mixing signals, the mixers 71, 73 and 75 can be implemented using an analog CMOS IC switch.

As those who are familiar with Fourier analysis of signals will appreciate, a periodic squarewave can be represented by the sum of a fundamental sinusoid having the same period as the squarewave and higher order odd harmonics of the fundamental frequency. Therefore, the multiplication being performed in the mixers 71, 73 and 75 can be expressed as follows:

$$M_{71} = \begin{array}{l} (A_0 \ COS[\frac{2\pi\theta}{\lambda}] \ COS[2\pi F_0 t]) \ \times \\ (COS[2\pi F_0 t] \ + \ ODD \ HARMONICS) \ \times \\ (COS[2\pi F_{IF} t] \ + \ ODD \ HARMONICS) \end{array}$$

$$M_{73} = \begin{array}{l} (A_0 \ COS[\frac{2\pi\theta}{\lambda} + \frac{\pi}{3}] \ COS[2\pi F_0 t]) \ \times \\ (COS[2\pi F_0 t] \ + \ ODD \ HARMONICS) \ \times \\ (COS[2\pi F_{IF} t + \frac{\pi}{3}] \ + \ ODD \ HARMONICS) \end{array}$$

$$M_{75} = \begin{array}{l} (A_0 \ COS[\frac{2\pi\theta}{\lambda} + \frac{2\pi}{3}] \ COS[2\pi F_0 t]) \ \times \\ (COS[2\pi F_0 t] \ + \ ODD \ HARMONICS) \ \times \\ (COS[2\pi F_{IF} t + \frac{2\pi}{3}] \ + \ ODD \ HARMONICS) \end{array} \qquad (2)$$

Performing this multiplication and rearranging the terms (ignoring the high frequency odd harmonics) results in the following expressions for the outputs $M_{71}$, $M_{73}$ and $M_{75}$ of the mixers 71, 73 and 75:

$$M_{71} = \frac{A_0}{4}(COS[2\pi F_{IF} t + \theta] + COS[2\pi F_{IF} t - \theta])$$

$$M_{73} = \frac{A_0}{4}(COS[2\pi F_{IF} t + \theta + \frac{2\pi}{3}] + COS[2\pi F_{IF} t - \theta])$$

$$M_{75} = \frac{A_0}{4}(COS[2\pi F_{IF} t + \theta + \frac{4\pi}{3}] + COS[2\pi F_{IF} t - \theta]) \qquad (3)$$

These signals are then added together in the adder 93 to give:

$$V_{OUT} = \frac{3A_0}{4}(COS[2\pi F_{IF} t - \theta]) \qquad (4)$$

Therefore the output signal from the adder 93 includes a single sinusoid at the intermediate frequency whose phase varies with the angular position (θ) of the rotatable shaft. As those skilled in the art will appreciate, the other intermediate frequency components cancel due to the particular choice of the phase of each of the intermediate frequency mixing signals. The output $V_{OUT}$ from the adder will also contain high frequency odd harmonic components, but these are removed by the low pass filter 95. The single intermediate frequency component in $V_{OUT}$ is then supplied to the comparator 97, where it is converted into a corresponding squarewave by comparing it with a reference voltage $V_{REF}$.

In order to measure the phase of this single intermediate component, the squarewave signal output by the comparator 97 is applied to the reset input (R) of a set-reset latch 99. The set input (S) of the latch 99 receives a squarewave signal 100 generated by the digital waveform generator 61. In this embodiment, the squarewave signal 100 has the same fundamental frequency $F_{IF}$ and phase as the second mixing component $V_2$ applied to mixer 71. The squarewave signal 100 may be passed through a low pass filter corresponding to low pass filter 95 and then compared with the reference voltage $V_{REF}$ prior to being applied to the set input of the latch 99. This reduces the effect of offset errors caused by temperature drift of the electronic components, since both signals applied to the input of the latch 99 will have been processed by similar electronics.

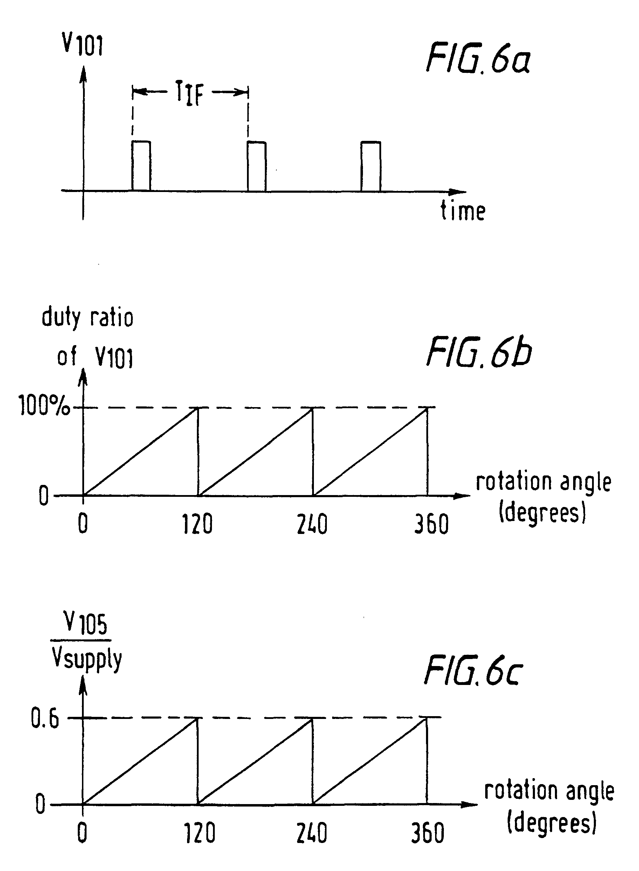

Figure 6a shows the resulting Q output signal 101 from the latch 99. As shown, output signal 101 is a periodic squarewave signal having a period ($T_{IF}$) the same as the second mixing components $V_2$ applied to the mixers 71, 73 and 75 and a duty ratio which varies with the angular position (θ) of the rotatable shaft 1. Figure 6b illustrates the way in which the duty ratio of the output signal 101 ($V_{101}$) varies with the rotation angle of the rotatable shaft. As shown, the duty ratio varies in a sawtooth manner, repeating every 120° of rotation of the rotatable shaft 1.

In this embodiment the output signal 101 from the latch 99 is also applied to the input of a low pass filter 103 which removes all the time varying components to leave an output signal 105 representing the amount of DC signal present in the output signal 101. As shown in Figure 6c, the ratio of the output signal 105 ($V_{105}$) to the supply voltage $V_{supply}$ also varies in a sawtooth manner (with a maximum value of 0.6), repeating every 120° of rotation of the rotatable shaft 1.

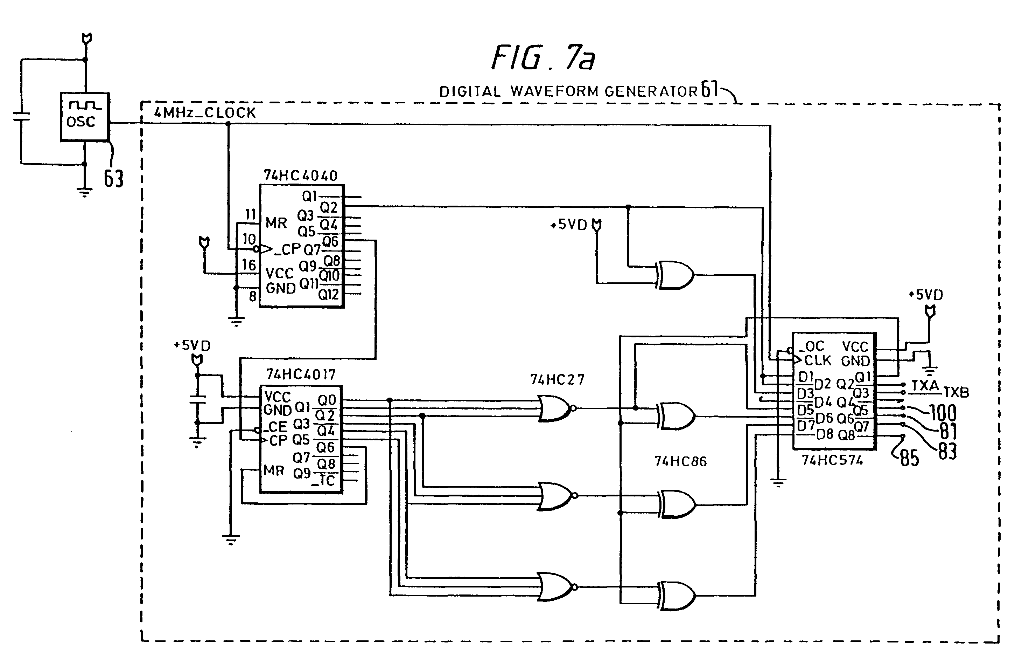

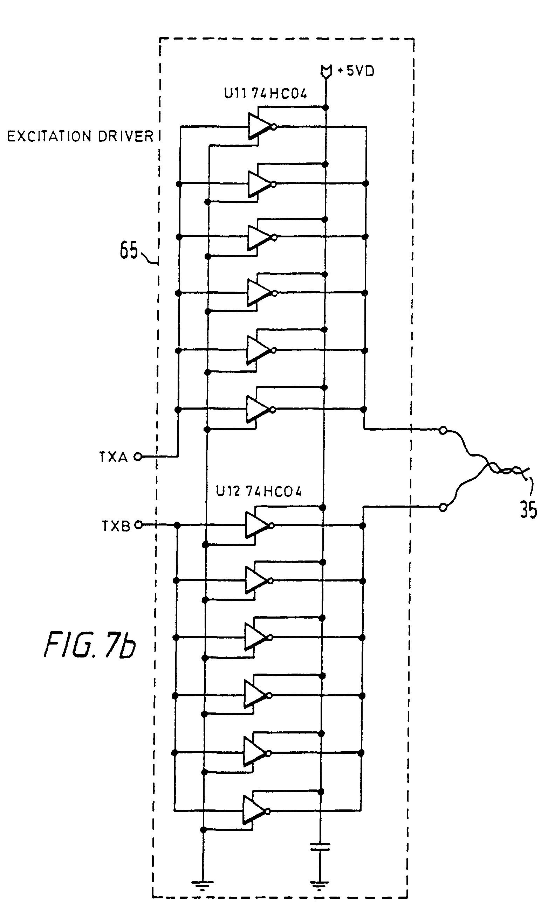

Figures 7a-7d illustrate a circuit diagram of the excitation and processing circuitry 60 schematically shown in Figure 5. In particular, Figure 7a is a circuit diagram showing the crystal oscillator 63 and the digital waveform generator 61. As shown, the crystal oscillator 63 generates a 4 MHz signal which is applied to various counters and logic gates of the digital waveform generator 61. The waveform generator 61 outputs two signals TXA and TXB which are applied to the excitation driver 65 shown in Figure 7b and signals 100, 81, 83 and 85 which are used in the processing circuitry. Figure 7b illustrates the circuit diagram of the excitation driver 65 which receives the signals TXA and TXB from the digital waveform generator 61 and outputs the excitation signal to the twisted wire pair 35 which, as shown in Figure 2a, is connected to the excitation coil 33.

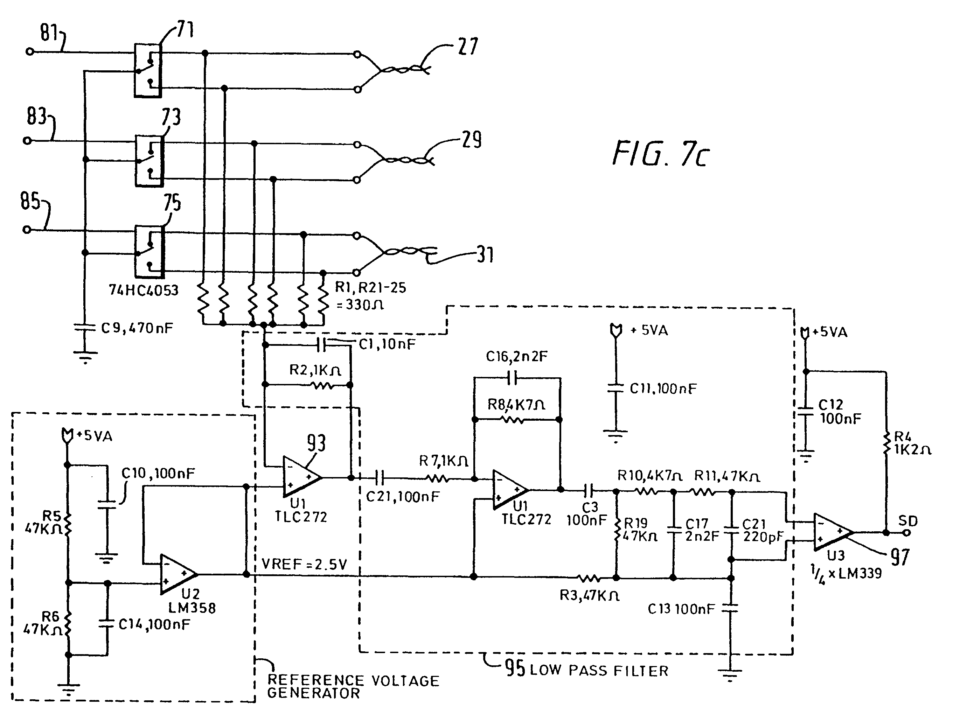

Figure 7c is a circuit diagram showing part of the processing circuitry shown in Figure 5. As shown, the ends of the twisted wire pairs 27, 29 and 31 are connected to the input of a triple change over CMOS switch which forms the mixers 71, 73 and 75. The CMOS switch also receives signals 81, 83 and 85 output from the digital waveform generator 61 shown in Figure 7a. Figure 7c also shows the adder 93 which adds the signals from the mixers 71, 73 and 75, the low pass filter 95 which filters out the high frequency odd harmonic components from the output of the adder 93 and the comparator 97 which compares the filtered output signal with a reference voltage $V_{REF}$. As illustrated in Figure 7c, the reference voltage $V_{REF}$ equals 2.5 volts, since the input signal varies between zero and positive five volts.

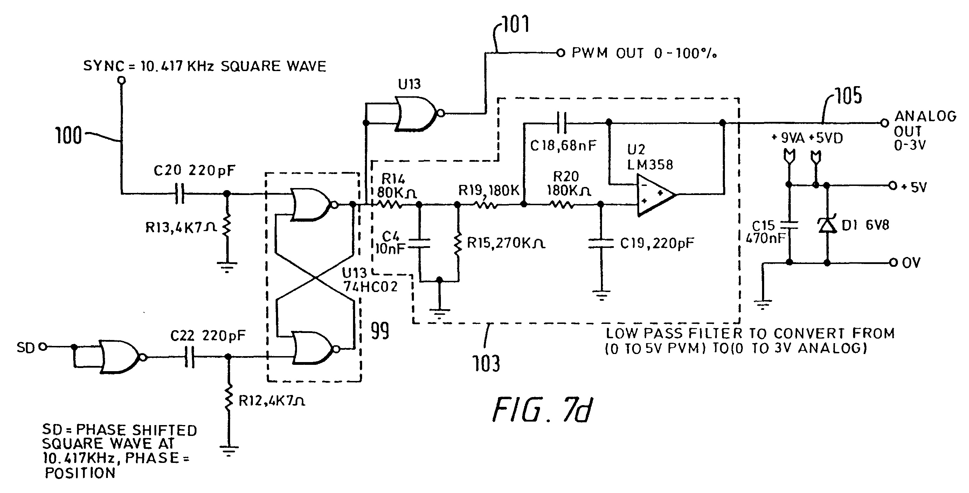

Figure 7d shows a circuit diagram of the rest of the processing circuitry shown in Figure 5. In particular, Figure 7d shows the set-reset latch 99 and the low pass filter 103 used to filter the output signal 101 from the latch 99 to produce the output signal 105.

As those skilled in the art will appreciate, there are a number of advantages of the processing circuitry described above as compared with, for example, the processing circuitry described in the applicant's earlier International Application WO95/31696. In particular, the processing circuitry described above is able to produce an output signal which varies in dependence upon the rotational position (θ) of the rotatable shaft which is relatively insensitive to variations in the gap between the sense coils 21, 23 and 25 and the resonant circuit 41. This is because the phase of the output signal from the low pass filter 95 does not depend upon the abovementioned coupling coefficient $A_0$. The processing circuitry 60 described above also has the advantage that it continuously outputs a signal which is indicative of the rotational angle of the rotatable shaft 1. Whereas, with the processing circuitry described in WO95/31696, the abovementioned arc-tangent calculation has to be performed each time a position measurement is required in order to generate an output signal.

Although the embodiment described above uses three sense coils, the processing circuitry could be adapted to receive and process signals from any number of sense coils. Additionally, as those skilled in the art will appreciate, it is not necessary for the sense coils to be evenly spaced over the measurement path. Further still, a different weighting could be applied to the signals output from the different mixers.

In the general case where there are n sense coils spaced over the measurement direction and a weighting is applied to the output of each mixer, then the output of the low pass filter 95 will have the following general form:

$$V_{OUT} = \begin{array}{l} \dfrac{A_0}{4} COS[2\pi F_{IF}t + \theta] \, (w_0 + w_1 COS[\phi_1 + \psi_1] \; + \; . \; . \; + \; w_{n-1} COS[\phi_{n-1} + \psi_{n-1}]) \\[2mm] + \; \dfrac{A_0}{4} COS[2\pi F_{IF}t - \theta] \, (w_0 + w_1 COS[\phi_1 - \psi_1] \; + \; . \; . \; + \; w_{n-1} COS[\phi_{n-1} - \psi_{n-1}]) \\[2mm] - \; \dfrac{A_0}{4} SIN[2\pi F_{IF}t + \theta] \, (w_1 SIN[\phi_1 - \psi_1] \; + \; . \; . \; + \; w_{n-1} SIN[\phi_{n-1} - \psi_{n-1}]) \\[2mm] - \; \dfrac{A_0}{4} SIN[2\pi F_{IF}t - \theta] \, (w_1 SIN[\phi_1 - \psi_1] \; + \; . \; . \; + \; w_{n-1} SIN[\phi_{n-1} - \psi_{n-1}]) \end{array}$$

Where $w_i$ is the weighting applied to the output signal from mixer i; $\phi_i$ is the phase of the intermediate frequency component applied to mixer i and $\psi_i$ is the abovementioned sense signal phase of the signal received from sense coil i. As those skilled in the art will appreciate, there are many different values of $w_i$, $\phi_i$ and $\psi_i$ which will result in $V_{OUT}$ reducing to a single sinusoidal component which varies with the rotation angle ($\theta$) of the rotatable shaft 1. When the weights ($w_i$) are the same, and when n sense coils are evenly spaced over the measurement path, the following values of $\phi_i$ will result in $V_{OUT}$ reducing to a signal sinusoid:

$$|\phi_i| = \psi_i = \frac{i\pi}{n}$$

Although the position encoder described in the above embodiment is a rotary position encoder, the above processing circuitry could be used for processing the signals from a linear position encoder or a radial position encoder, such as those described in the applicant's earlier International Patent Application WO95/31696.

Although the embodiment described uses a non-contact inductive position encoder, as those skilled in the art will appreciate, the processing circuitry described above could be used to process the signals from a position encoder which uses capacitive coupling or to process the signals from a position encoder which has direct contact between the two relatively movable members.

**Claims**

1. A position detector comprising:

first and second members mounted for relative movement in a measurement path, said first member comprising a plurality of sensing circuits, each extending along said measurement path and being offset from each other in said measurement path and said second member comprising generating means for generating, in each of said sensing circuits, a time varying periodic carrier signal whose amplitude varies sinusoidally with the relative position between said generating means and the respective sensing circuit and wherein, due the offset between said sensing circuits, the sinusoidal variation of the amplitude of the signals generated in said sensing circuits are out of phase with respect to each other;
means for combining a first periodic time varying signal having the same period as said carrier signal with a respective one of a plurality of second periodic time varying signals, each having the same predetermined period which is greater than the period of said carrier signal and each having a different predetermined phase, to generate a plurality of combined time varying signals;
means for multiplying each of the signals generated in said plurality of sensing circuits with a respective one of the plurality of combined signals generated by said combining means; and
means for adding the signals from said multiplying means to provide an output signal;

wherein said predetermined phases of said plurality of second periodic time varying signals are determined so that said output signal from said adding means contains a single periodic component having the same predetermined period as said second periodic time varying signals and whose phase varies with the relative position between said first and second members.

2. A position detector according to claim 1, wherein the predetermined phases of said plurality of second periodic time varying signals are determined such that their magnitude equals the phase of the corresponding received signal with which it is multiplied.

3. A position detector according to any preceding claim, further comprising a waveform generator which is arranged to generate said first and second periodic time varying signals.

4. A position detector according to claim 3, wherein said first and second periodic time varying signals are squarewave signals.

5. A position detector according to claim 4, wherein said combining means is arranged to combine the two different periodic time varying signals prior to multiplication with the respective received signal using an XOR gate.

6. A position detector according to claim 4 or 5, wherein said multiplying means comprises a CMOS IC switch.

7. A position detector according to any preceding claim, further comprising means for filtering said output signal to remove components not having the same predetermined period as said second periodic time varying signals.

8. A position detector according to claim 7, wherein the output of said filtering means is substantially sinusoidal having said predetermined period, and wherein said apparatus further comprises means for converting said sinusoidal signal into a squarewave signal having said predetermined period and said phase which varies with said relative position.

9. A position detector according to claim 8, wherein said converting means comprises a comparator for comparing said sinusoidal signal with a reference signal.

10. A position detector according to claim 8 or 9, further comprising means for processing said squarewave signal having said predetermined period whose phase varies with said relative position to output a different squarewave signal whose duty ratio varies with said relative phase.

11. A position detector according to claim 12, wherein said processing means comprises a set-reset latch.

12. A position detector according to any preceding claim, wherein said plurality of sensing circuits are inductively coupled to said generator means.

13. A position detector according to any preceding claim, wherein said sensing circuits are capacitively coupled to said generator means.

14. A position detector according to any preceding claim, wherein said sensing circuits extend over a linear path.

15. A position detector according to any preceding, wherein said sensing circuits extend in a rotary path.

16. A position detector according to any of preceding, wherein said sensing circuits extend in a radial path.

17. A position detector according to any preceding claim, wherein the modulus of the phase of said second periodically varying signals is given by $(i\pi)/n$, where n is the number of sensing circuits.

18. A method of determining the relative position between first and second members which are relatively moveable in a measurement path, said first member comprising a plurality of sensing circuits, each extending along said measurement path and being offset from each other in said measurement path, said method comprising steps of:

using a generator on said second member to generate, in each of said sensing circuits, a time varying periodic carrier signal whose amplitude varies sinusoidally with the relative position between the second member and the respective sensing circuit on the first member, and wherein, due to the offset between said sensing circuits, the sinusoidal variation of the amplitude of the signals generated in said sensing circuits are out of phase with respect to each other;
combining a first periodic time varying signal having the same period as said carrier signal with a respective one of a plurality of second periodic time varying signals, each having the same predetermined period which

8

is greater than the period of said carrier signal and each having a different predetermined phase, to generate a plurality of combined time varying signals;

multiplying each of the signals generated in said plurality of sensing circuits with a respective one of the plurality of combined signals generated in said combining step; and

adding the signals from said multiplying step to provide an output signal;

wherein said predetermined phases of said plurality of second periodic time varying signals are determined so that said output signal from said adding means contains a single periodic component having the same predetermined period as said second periodic time varying signals and whose phase varies with the relative position between said first and second members.

19. A method according to claim 18, wherein the predetermined phases of said plurality of second periodic time varying signals are determined such that their modulus equals the phase of the corresponding received signal with which it is multiplied.

20. A method according to claim 18 or 19, comprising the step of using a signal generator to generate each of said periodic time varying signals.

21. A method according to claim 20, wherein said first and second periodic time varying signals are squarewave signals.

22. A method according to claim 21, wherein said combining step uses an XOR gate to combine said first and second periodic time varying signals prior to multiplication with the respective received signal.

23. A method according to claim 21 or 22, wherein a CMOS IC switch is used to multiply said time varying signals.

24. A method according to any of claims 18 to 23, further comprising the step of filtering said output signal to remove components not having the same predetermined period as said second periodic time varying signals.

25. A method according to claim 24, wherein the output of said filtering step is a sinusoidal signal having said predetermined period, and wherein said method further comprises the step of converting said sinusoidal signal into a squarewave signal having said predetermined period and said phase which varies with said relative position.

26. A method according to claim 25, wherein said converting step compares said sinusoidal signal with a reference signal.

27. A method according to claim 25 or 26, further comprising the step of processing said squarewave signal having said predetermined period whose phase varies with said relative position to output a different squarewave signal whose duty ratio varies with said relative phase.

28. A method according to claim 27, wherein said processing step uses a set-reset latch.

29. A processing apparatus for processing a plurality of signals received from a position encoder used to encode the relative positions of two relatively movable members, wherein each of said plurality of signals varies sinusoidally with said relative position and out of phase with respect to each other, the apparatus comprising:

means for combining a first periodic time varying signal having a first period with a respective one of a plurality of second periodic time varying signals, each having the same predetermined period which is greater than the period of said first periodic time varying signal and each having a different predetermined phase, to generate a plurality of combined time varying signals;

means for multiplying each of said received signals with a respective one of the plurality of combined signals generated by said combining means; and

means for adding the signals from said multiplying means to provide an output signal, and wherein said predetermined phases of said periodically varying signals are determined so that, in use, the output signal from said adding means contains a single periodic component having said predetermined period whose phase varies with the relative position of the relatively moveable members.

**Patentansprüche**

1.  Positionsdetektor mit:

    einem ersten und einem zweiten, -in einem Messpfad relativ bewegbaren Elementen, wobei das erste Element mehrere Sensorschaltkreise aufweist, die jeweils entlang des Messpfads verlaufen und gegeneinander in dem Messpfad versetzt sind, und wobei das zweite Element eine Erzeugungsvorrichtung aufweist, um in jedem der Sensorschaltkreise ein sich zeitlich änderndes, periodisches Trägersignal zu erzeugen, dessen Amplitude sich sinusförmig mit der relativen Position von Erzeugungsvorrichtung und entsprechendem Sensorschaltkreis ändert, und wobei, abhängig von dem Versatz zwischen den Sensorschaltkreisen, die in den Sensorschaltkreisen erzeugten sinusförmigen Signalamplitudenänderungen zueinander phasenverschoben sind;
    einer Vorrichtung zum Kombinieren eines ersten periodischen, sich zeitlich ändernden, das die gleiche Periode wie das Trägersignal aufweist, mit einem entsprechenden Signal der mehreren zweiten, periodischen, sich zeitlich ändernden Signale, die jeweils die gleiche vorbestimmte Periode, die größer ist als die Periode des Trägersignals, und eine unterschiedliche, vorbestimmte Phase aufweisen, um mehrere kombinierte, sich zeitlich ändernde Signale zu erzeugen;
    einer Vorrichtung zum Multiplizieren jedes der in den mehreren Sensorschaltkreisen erzeugten Signale mit einem entsprechenden der mehreren, von der Kombinationsvorrichtung erzeugten, kombinierten Signale; und
    einer Vorrichtung zum Addieren der Multipliziervorrichtungssignale, um ein Ausgangssignal bereitzustellen;

    wobei die vorbestimmten Phasen der mehreren zweiten, sich zeitlich ändernden Signale derart festgelegt sind, dass das Ausgangssignal der Additionsvorrichtung einen einzigen periodischen Anteil enthält, der die gleiche vorbestimmte Periode wie die zweiten, sich zeitlich ändernden Signale aufweist, und dessen Phase sich mit der relativen Position von erstem und zweitem Element ändert.

2.  Positionsdetektor nach Anspruch 1, wobei die vorbestimmten Phasen der mehreren zweiten, sich zeitlich ändernden Signale derart festgelegt sind, dass ihre Größe der Phase des entsprechenden, empfangenen Signals, mit dem sie multipliziert wird, gleicht.

3.  Positionsdetektor nach einem der vorhergehenden Ansprüche mit einem Wellengenerator, der so angeordnet ist, dass er das erste und die zweiten, sich zeitlich ändernden Signale erzeugt.

4.  Positionsdetektor nach Anspruch 3, wobei das erste und die zweiten periodischen, sich zeitlich ändernde Signale Rechtecksignale sind.

5.  Positionsdetektor nach Anspruch 4, wobei die Kombinationsvorrichtung so angeordnet ist, dass die zwei unterschiedlichen, periodischen, sich zeitlich ändernden Signale vor der Multiplikation mit dem entsprechenden empfangenden Signal mittels eines XOR-Gates kombiniert werden.

6.  Positionsdetektor nach Anspruch 4 oder 5, wobei die Multiplikationsvorrichtung ein CMOS-IC-Switch umfasst.

7.  Positionsdetektor nach einem der vorhergehenden Ansprüche, mit einer Vorrichtung zum Filtern des Ausgangssignals, um Anteile, die nicht die gleiche vorbestimmte Periode wie die zweiten periodischen, sich zeitlich ändernden Signale aufweisen, zu entfernen.

8.  Positionsdetektor nach Anspruch 7, wobei das Ausgabesignal der Filtervorrichtung im wesentlichen sinusförmig mit einer festgelegten Periode ist, und wobei das Gerät eine Vorrichtung zum Konvertieren des sinusförmigen Signals in ein Rechtecksignal mit der vorbestimmten Periode und der Phase, die sich mit der relativen Position ändert, umfasst.

9.  Vorrichtung nach Anspruch 8, wobei die Konvertiervorrichtung eine Vergleichseinheit zum Vergleichen des sinusförmigen Signals mit einem Referenzsignal umfasst.

10. Positionsdetektor nach Anspruch 8 oder 9 mit einer Vorrichtung zum Prozessieren des Rechtecksignals mit der vorbestimmten Periode, dessen Phase sich mit der relativen Position ändert, um ein anderes Rechtecksignal auszugeben, dessen Tastverhältnis sich mit der relativen Phase ändert.

11. Positionsdetektor nach Anspruch 12, wobei die Prozessiervorrichtung ein Set-Reset-Latch umfasst.

**12.** Positionsdetektor nach einem der vorhergehenden Ansprüche, wobei die mehreren Sensorschaltkreise induktiv mit der Erzeugungsvorrichtung gekoppelt sind.

**13.** Positionsdetektor nach einem der vorhergehenden Ansprüche, wobei die Sensorschaltkreise kapazitativ mit der Erzeugungsvorrichtung gekoppelt sind.

**14.** Positionsdetektor nach einem der vorhergehenden Ansprüche, wobei sich die Sensorschaltkreise über einen linearen Pfad erstrecken.

**15.** Positionsdetektor nach einem der vorhergehenden Ansprüche, wobei sich die Sensorschaltkreise in einem umlaufenden Pfad erstrecken.

**16.** Positionsdetektor nach einem der vorhergehenden Ansprüche, wobei sich die Sensorschaltkreise in einem radialen Pfad erstrecken.

**17.** Positionsdetektor nach einem der vorhergehenden Ansprüche, wobei der Phasenmodulus der zweiten sich periodisch ändernden Signale gegeben ist durch (iπ)/n, wobei n die Anzahl der Sensorschaltkreise ist.

**18.** Verfahren zum Bestimmen der relativen Position von einem ersten und einem zweiten, in einem Messpfad relativ beweglichen Element, wobei das erste Element mehrere Sensorschaltkreise aufweist, die jeweils entlang des Messpfads verlaufen und gegeneinander in dem Messpfad versetzt sind, mit folgenden Schritten:

Benutzen einer Erzeugungsvorrichtung auf dem zweiten Element, um in jedem der Sensorschaltkreise ein sich zeitlich änderndes, periodisches Trägersignal zu erzeugen, dessen Amplitude sich sinusförmig mit der relativen Position von zweitem Element und entsprechendem Sensorschaltkreis des ersten Elements ändert, und wobei, abhängig von dem Versatz zwischen den Sensorschaltkreisen, die sinusförmigen in den Sensorschaltkreisen erzeugten Signalamplitudenänderungen zueinander phasenverschoben sind;
Kombinieren eines ersten periodischen, sich zeitlich ändernden Signals, das die gleiche Periode wie das Trägersignal aufweist, mit einem entsprechenden der mehreren zweiten periodischen, sich zeitlich ändernden Signale, die jeweils die gleiche vorbestimmte Periode, die größer ist als die Periode des Trägersignals, und eine unterschiedliche vorbestimmte Phase aufweisen, um mehrere kombinierte, sich zeitlich ändernde Signale zu erzeugen;
Multiplizieren jedes der in den mehreren Sensorschaltkreisen erzeugten Signale mit einem entsprechenden der mehreren in dem Kombinationsschritt erzeugten, kombinierten Signale; und
Addieren der Signale aus dem Multiplikationsschritt, um ein Ausgangssignal bereitzustellen;

wobei die vorbestimmten Phasen der mehreren zweiten periodischen, sich zeitlich ändernden Signale derart festgelegt sind, dass das Ausgangssignal aus dem Additionsschritt einen einzigen periodischen Anteil enthält, der die gleiche vorbestimmte Periode wie die zweiten periodischen, sich zeitlich ändernden Signale aufweist, und dessen Phase sich mit der relativen Position von erstem und zweitem Element ändert.

**19.** Verfahren nach Anspruch 18, wobei die vorbestimmten Phasen der mehreren zweiten periodischen, sich zeitlich ändernden Signale derart festgelegt werden, dass ihr Modulus der Phase des entsprechenden empfangenen Signals, mit dem er multipliziert wird, gleicht.

**20.** Verfahren nach Anspruch 18 oder 19, wobei mittels eines Signalgenerators jedes der periodischen, sich zeitlich ändernden Signale erzeugt wird.

**21.** Verfahren nach Anspruch 20, wobei die ersten und zweiten periodischen, sich zeitlich ändernden Signale Rechtecksignale sind.

**22.** Verfahren nach Anspruch 21, wobei im Kombinationsschritt ein XOR-Gate benutzt wird, um das erste und zweite periodische, sich zeitlich ändernde Signal vor der Multiplikation mit dem entsprechenden empfangenen Signal zu kombinieren.

**23.** Verfahren nach Anspruch 21 oder 22, wobei ein CMOS-IC-Switch benutzt wird, um die sich zeitlich ändernden Signale zu multiplizieren.

**24.** Verfahren nach einem der Ansprüche 18 bis 23, wobei das Ausgangssignal gefiltert wird, um Anteile, die nicht dieselbe vorbestimmte Periode wie die zweiten periodischen, sich zeitlich ändernden Signale aufweisen, zu entfernen.

**25.** Verfahren nach Anspruch 24, wobei das Ausgabesignal des Filterschritts ein sinusförmiges Signal mit der vorbestimmten Periode ist, und wobei in dem Verfahren das sinusförmige Signal in ein Rechtecksignal mit der vorbestimmten Periode konvertiert wird, dessen Phase sich mit der relativen Position ändert.

**26.** Verfahren nach Anspruch 25, wobei in dem Konvertierungsschritt das sinusförmige Signal mit einem Referenzsignal verglichen wird.

**27.** Verfahren nach Anspruch 25 oder 26, wobei das Rechtecksignal mit der vorbestimmten Periode, dessen Phase sich mit der relativen Position ändert, prozessiert wird, um ein anderes Rechtecksignal auszugeben, dessen Tastverhältnis sich mit der relativen Phase ändert.

**28.** Verfahren nach Anspruch 27, wobei in dem Prozessierschritt ein Set-Reset-Latch verwendet wird.

**29.** Prozessiergerät zum Prozessieren mehrerer von einem Positionsverschlüsseler, der die relativen Positionen zweier relativ beweglicher Elemente verschlüsselt, empfangener Signale, wobei sich jedes der mehreren Signale sinusförmig mit der relativen Position ändert und sie zueinander phasenverschoben sind, mit:

einer Vorrichtung zum Kombinieren eines ersten periodischen, sich zeitlich ändernden Signals, das eine ersten Periode aufweist, mit einem entsprechenden der mehreren zweiten, sich zeitlich ändernden periodischen Signalen, die jeweils die gleiche vorbestimmte Periode, die größer ist als die Periode des ersten periodischen, sich zeitlich ändernden Signals, und eine unterschiedliche vorbestimmte Phase aufweisen, um mehrere kombinierte, sich zeitlich ändernde Signale zu erzeugen;
einer Vorrichtung zum Multiplizieren jedes der empfangenen Signale mit einem entsprechenden der mehreren, von der Kombinationsvorrichtung erzeugten, kombinierten Signale; und
einer Vorrichtung zum Addieren der Multiplikationsvorrichtungssignale, um ein Ausgangssignal bereitzustellen,

wobei die vorbestimmten Phasen der sich periodisch ändernden Signale derart festgelegt sind, dass das Ausgangssignal der Additionsvorrichtung einen einzigen periodischen Anteil mit einer vorbestimmten Periode enthält, dessen Phase sich mit der relativen Position der relativ beweglichen Elemente ändert.

**Revendications**

**1.** Détecteur de position comprenant :

un premier et un second éléments montés de manière mobile l'un par rapport à l'autre sur un chemin de mesure, ledit premier élément comprenant une pluralité de circuits de détection dont chacun parcourt ledit chemin de mesure et est décalé par rapport aux autres sur ledit chemin de mesure et ledit second élément comprenant des moyens de génération pour générer, dans chacun desdits circuits de détection, un signal porteur périodique variant dans le temps dont l'amplitude varie de manière sinusoïdale avec la position relative entre lesdits moyens de génération et le circuit de détection correspondant, et dans lequel, du fait du décalage entre lesdits circuits de détection, les variations sinusoïdales d'amplitude des signaux générés dans lesdits circuits de détection sont déphasées les unes par rapport aux autres ;
des moyens pour combiner un premier signal périodique variant dans le temps doté de la même période que ledit signal porteur avec un signal correspondant parmi une pluralité de seconds signaux périodiques variant dans le temps, chacun ayant la même période prédéterminée qui est supérieure à la période dudit signal porteur et chacun ayant une phase prédéterminée différente, pour générer une pluralité de signaux combinés variant dans le temps ;
des moyens pour multiplier chacun des signaux générés dans ladite pluralité de circuits de détection avec un signal correspondant parmi la pluralité de signaux combinés générés par lesdits moyens de combinaison ; et
des moyens pour additionner les signaux desdits moyens de multiplication pour produire un signal de sortie ;
lesdites phases prédéterminées de ladite pluralité de seconds signaux périodiques variant dans le temps étant déterminées de telle sorte que ledit signal de sortie desdits moyens d'addition contient un élément périodique unique doté de la même période prédéterminée que lesdits seconds signaux périodiques variant dans le temps et dont la phase varie avec la position relative entre lesdits premier et second éléments.

2. Détecteur de position selon la revendication 1, dans lequel les phases prédéterminées de ladite pluralité de seconds signaux périodiques variant dans le temps sont déterminées de telle sorte que leur module est égal à la phase du signal reçu correspondant avec lequel il est multiplié.

3. Détecteur de position selon l'une quelconque des revendications précédentes, comprenant en outre un générateur de formes d'onde qui est agencé pour générer lesdits premier et second signaux périodiques variant dans le temps.

4. Détecteur de position selon la revendication 3, dans lequel lesdits premier et second signaux périodiques variant dans le temps sont des signaux carrés.

5. Détecteur de position selon la revendication 4, dans lequel lesdits moyens de combinaison sont disposés pour combiner les deux signaux périodiques variant dans le temps différents avant de les multiplier avec le signal reçu correspondant à l'aide d'une porte XOR.

6. Détecteur de position selon la revendication 4 ou 5, dans lequel lesdits moyens de multiplication comprennent un commutateur CI CMOS.

7. Détecteur de position selon l'une quelconque des revendications précédentes, comprenant en outre des moyens pour filtrer ledit signal de sortie afin d'éliminer les éléments qui n'ont pas la même période prédéterminée que lesdits seconds signaux périodiques variant dans le temps.

8. Détecteur de position selon la revendication 7, dans lequel la sortie desdits moyens de filtrage est sensiblement sinusoïdale et dotée de ladite période prédéterminée, et dans lequel ledit appareil comprend en outre des moyens pour convertir ledit signal sinusoïdal en un signal carré doté de ladite période prédéterminée et de ladite phase qui varie avec ladite positon relative.

9. Détecteur de position selon la revendication 8, dans lequel lesdits moyens de conversion comprennent un comparateur pour comparer ledit signal sinusoïdal avec un signal de référence.

10. Détecteur de position selon la revendication 8 ou 9, comprenant en outre des moyens pour traiter ledit signal carré doté de ladite période prédéterminée dont la phase varie avec ladite position relative pour émettre un signal carré différent dont le taux de remplissage varie avec ladite phase relative.

11. Détecteur de position selon la revendication 10, dans lequel lesdits moyens de traitement comprennent une bascule RS.

12. Détecteur de position selon l'une quelconque des revendications précédentes, dans lequel ladite pluralité de circuits de détection est couplée de manière inductive auxdits moyens de génération.

13. Détecteur de position selon l'une quelconque des revendications précédentes, dans lequel lesdits circuits de détection sont couplés de manière capacitive auxdits moyens de génération.

14. Détecteur de position selon l'une quelconque des revendications précédentes, dans lequel lesdits circuits de détection parcourent un chemin linéaire.

15. Détecteur de position selon l'une quelconque des revendications précédentes, dans lequel lesdits circuits de détection parcourent un chemin rotatif.

16. Détecteur de position selon l'une quelconque des revendications précédentes, dans lequel lesdits circuits de détection parcourent un chemin radial.

17. Détecteur de position selon l'une quelconque des revendications précédentes, dans lequel le module de la phase desdits seconds signaux variant périodiquement est donné par $(i\Pi) / n$, où n est le nombre de circuits de détection.

18. Procédé pour déterminer la position relative entre les premier et second éléments qui sont mobiles l'un par rapport à l'autre sur un chemin de mesure, ledit premier élément comprenant une pluralité de circuits de détection dont chacun parcourt ledit chemin de mesure et est décalé par rapport aux autres sur ledit chemin de mesure, ledit procédé comprenant les étapes suivantes :

utilisation d'un générateur sur ledit second élément pour générer, dans chacun desdits circuits de détection, un signal porteur périodique variant dans le temps dont l'amplitude varie de manière sinusoïdale avec la position relative entre le second élément et le circuit de détection correspondant sur le premier élément, et dans lequel, les variations sinusoïdales d'amplitude des signaux générés dans lesdits circuits de détection sont déphasées les unes par rapport aux autres du fait du décalage entre lesdits circuits de détection ;

combinaison d'un premier signal périodique variant dans le temps doté de la même période que ledit signal porteur avec un signal correspondant parmi une pluralité de seconds signaux périodiques variant dans le temps, chacun ayant la même période prédéterminée qui est supérieure à la période dudit signal porteur et chacun ayant une phase prédéterminée différente, pour générer une pluralité de signaux combinés variant dans le temps ;

multiplication de chacun des signaux générés dans ladite pluralité de circuits de détection avec un signal correspondant parmi la pluralité de signaux combinés générés à ladite étape de combinaison ; et

addition des signaux de ladite étape de multiplication pour produire un signal de sortie ;

lesdites phases prédéterminées de ladite pluralité de seconds signaux périodiques variant dans le temps étant déterminées de telle sorte que ledit signal de sortie desdits moyens d'addition contient un élément périodique unique doté de la même période prédéterminée que lesdits seconds signaux périodiques variant dans le temps et dont la phase varie avec la position relative entre lesdits premier et second éléments.

19. Procédé selon la revendication 18, dans lequel les phases prédéterminées de ladite pluralité de seconds signaux périodiques variant dans le temps sont déterminées de telle sorte que leur module est égal à la phase du signal reçu correspondant avec lequel il est multiplié.

20. Procédé selon la revendication 18 ou 19, comprenant l'étape d'utilisation d'un générateur de signaux pour générer chacun desdits signaux périodiques variant dans le temps.

21. Procédé selon la revendication 20, dans lequel lesdits premier et second signaux périodiques variant dans le temps sont des signaux carrés.

22. Procédé selon la revendication 21, dans lequel ladite étape de combinaison utilise une porte XOR pour combiner lesdits premier et second signaux périodiques variant dans le temps avant de les multiplier avec le signal reçu correspondant.

23. Procédé selon la revendication 21 ou 22, dans lequel un commutateur CI CMOS est utilisé pour multiplier lesdits signaux variant dans le temps.

24. Procédé selon l'une quelconque des revendications 18 à 23, comprenant en outre l'étape de filtrage dudit signal de sortie afin d'éliminer les éléments qui n'ont pas la même période prédéterminée que lesdits seconds signaux périodiques variant dans le temps.

25. Procédé selon la revendication 24, dans lequel la sortie de ladite étape de filtrage est un signal sinusoïdal doté de ladite période prédéterminée, et ledit procédé comprenant en outre l'étape de conversion dudit signal sinusoïdal en un signal carré doté de ladite période prédéterminée et de ladite phase qui varie avec ladite positon relative.

26. Procédé selon la revendication 25, dans lequel ladite étape de conversion compare ledit signal sinusoïdal avec un signal de référence.

27. Procédé selon la revendication 25 ou 26, comprenant en outre l'étape de traitement dudit signal carré doté de ladite période prédéterminée dont la phase varie avec ladite position relative pour émettre un signal carré différent dont le taux de remplissage varie avec ladite phase relative.

28. Procédé selon la revendication 27, dans lequel ladite étape de traitement utilise une bascule RS.

29. Appareil de traitement pour traiter une pluralité de signaux reçus d'un codeur de position utilisé pour coder les positions relatives de deux éléments mobiles l'un par rapport à l'autre, chacun de ladite pluralité de signaux variant de manière sinusoïdale avec ladite position relative et étant déphasé par rapport à l'autre, l'appareil comprenant :

des moyens pour combiner un premier signal périodique variant dans le temps doté d'une première période avec un signal correspondant parmi une pluralité de seconds signaux périodiques variant dans le temps, chacun ayant la même période prédéterminée qui est supérieure à la période dudit premier signal périodique variant dans le temps et chacun ayant une phase prédéterminée différente, pour générer une pluralité de signaux combinés variant dans le temps ;

des moyens pour multiplier chacun desdits signaux reçus avec un signal correspondant parmi la pluralité de signaux combinés générés par lesdits moyens de combinaison ; et

des moyens pour additionner les signaux desdits moyens de multiplication pour produire un signal de sortie, lesdites phases prédéterminées desdits signaux variant périodiquement étant déterminées de telle sorte que, en service, le signal de sortie desdits moyens d'addition contient un élément périodique unique doté de ladite période prédéterminée dont la phase varie avec la position relative des éléments mobiles l'un par rapport à l'autre.

FIG.1

FIG.3

FIG. 2a

FIG. 2b

FIG. 2c

## FIG.4

## FIG.5

$V_{101}$

*FIG.6a*

$T_{IF}$

time

duty ratio
of $V_{101}$

*FIG.6b*

100%

0

0      120      240      360

rotation angle
(degrees)

$\dfrac{V_{105}}{V_{supply}}$

*FIG.6c*

0.6

0

0      120      240      360

rotation angle
(degrees)

## FIG. 7a

DIGITAL WAVEFORM GENERATOR 61

EP 0 907 878 B1

FIG. 7b

FIG. 7c

74HC4053

C9,470nF

R1,R21-25 =330Ω

C1,10nF

R2,1KΩ

C16,2n2F

R8,4K7Ω

+5VA

C11,100nF

+5VA

C12 100nF

R4 1K2Ω

+5VA

C10,100nF

93

R5 47KΩ

U1 TLC272

R7,1KΩ

U1 TLC272

R10,4K7Ω  R11,47KΩ

C21,100nF

C3 100nF

R19 47KΩ

C17 2n2F

C21 220pF

SD

U3 ¼×LM339

97

R6 47KΩ

C14,100nF

U2 LM358

VREF=2.5V

R3,47KΩ

C13 100nF

REFERENCE VOLTAGE GENERATOR

95 LOW PASS FILTER

EP 0 907 878 B1

FIG. 7d

SYNC = 10.417 KHz SQUARE WAVE

SD = PHASE SHIFTED
SQUARE WAVE AT
10.417KHz, PHASE =
POSITION

LOW PASS FILTER TO CONVERT FROM
(0 TO 5V PVM) TO(0 TO 3V ANALOG)